# EUROPEAN PATENT APPLICATION

(11) **EP 4 197 848 A1**
(43) Date of publication of application: **21.06.2023**
(21) Application number: 21214760.7
(22) Date of filing: 15.12.2021
(51) Int. Cl.: B60L 53/16, B60L 53/18, B60L 53/302, H01R 9/11

(54) **EV CHARGING CONNECTOR AND EV CHARGING STATION**

(71) Applicant: ABB E-mobility B.V., 2629 JG Delft (NL)
(72) Inventor: GARCIA-FERRE, Francisco, 5400 Baden (CH); KAUFMANN, Lilian, 5413 Birmenstorf (CH); KHEIRI, Pedram, 5212 Hausen (CH); RAAIJMAKERS, Stefan, 2613 WN Delft (NL); ZOON, Wiebe, 2623 NM Delft (NL)
(74) Representative: Maiwald GmbH

(57) **Abstract**

The invention relates to an EV charging connector (100). The EV charging connector (100) comprises a hybrid cooling system with a first cooling device (105, 1036) for cooling a first portion of the connector (100) in an area of effect (120) of the first cooling device, and a second cooling device (108) for cooling a second portion of the connector in an area of effect (122) of the second cooling device. The first portion and the second portion are thermally connected to each other; and the area of effect of the first cooling device is configured for not overlapping or only insignificantly overlapping the area of effect of the second cooling device.

## Description

### Technical Field

The invention relates to an EV charging connector, an EV charging station, and a use of a first cooling device and a second cooling device for an EV charging connector.

### Background

Existing EV charging connectors either have an active cooling where cooling lines cool the cable and the contact, or passive cooing devices, such as cooling elements attached to the contact. Cooling the cable and contacts with cooling lines is inefficient, because the coolant is already hot when it arrives at the contact, and the heat flux in this area is high. Passive cooling devices on the other side are not sufficient for connectors that provide high charging currents, for example, above 500 A.

### Summary of the invention

There may be a desire to improve an EV charging connector with respect to cooling.

The problem is solved by the subject-matter of the independent claims. Embodiments are provided by the dependent claims, the following description and the accompanying figures.

The described embodiments similarly pertain to the EV (Electric Vehicle) charging connector, the EV charging station, and the use of a first cooling device and a second cooling device for an EV charging connector. Synergetic effects may arise from different combinations of the embodiments although they might not be described in detail.

Technical terms are used by their common sense. If a specific meaning is conveyed to certain terms, definitions of terms will be given in the following in the context of which the terms are used.

According to a first aspect, an EV charging connector is provided. The EV charging connector comprises a hybrid cooling system with a first cooling device for cooling a first portion of the connector in an area of effect of the first cooling device, and a second cooling device for cooling a second portion of the connector in an area of effect of the second cooling device. The first portion and the second portion are thermally connected to each other; and the area of effect of the first cooling device is configured for not overlapping or only insignificantly overlapping the area of effect of the second cooling device.

In other words, the first cooling device does not directly influence the second portion and vice versa. However, since the first and the second portions are thermally connected with each other, there is an indirect effect. The aim is that the each cooling device is fully used for the portion for which it is suited. The first portion may have different thermal characteristics such as heat flow than the second portion and thus the first cooling device may be of different type than the second cooling device. Nevertheless, cooling the first portion has a positive effect on the effectivity of the second device for cooling the second portion. Therefore, the cooling system is a hybrid cooling system.

The cooling devices are therefore specialized for the respective portion to be cooled, do not interfere with each other and can concentrate on their special portion, and have a positive effect on each other, which is achieved purely indirect.

Due to constructive reasons, limitations or conditions in the charging connector, it might be the case that the areas of effect are not perfectly separated. However, such an overlapping is assumed not to be significant with respect to the intended physical effect, and does not contradict the principle of the invention.

According to an embodiment, the EV charging connector comprises a cable and a contact. The first portion is the cable and the second portion is the contact.

The connector may further comprise an internal, electrically and environmentally sealed enclosure and an external enclosure. The contact is located inside the internal enclosure. There may be a contact, e.g. for DC+ and a contact for DC-. In this disclosure, it is spoken of one contact. However, all explanations apply also to (the) further contact(s). The cable is lead into the sealed enclosure, where the wires of the cable are connected to the contacts.

According to an embodiment, the first cooling device is configured to cool the cable actively by pumped coolant, and the second cooling device is configured for cooling the contact.

The cable in this disclosure is cooled by a coolant arriving in an incoming channel and return channel.

The larger part of total system losses happens in the cable, but at relatively small heat fluxes. This means, the losses are distributed over a relatively large area along the cable length. Actively cooled cables include a coolant passing along the cable from the charging station. Along this way the coolant absorbs nearly all of the losses produced by the cable. As the coolant reaches the end of the cable it enters the return conduit and at significantly elevated temperature returns to the charging station. Along the return flow, relatively lower heat is further absorbed by the coolant, and it may even happen that the returning coolant is actually cooled by the incoming coolant, if the conduits are not thermally sufficiently separated. In this situation, the temperature of the cable coolant at the end of the cable, i.e. in the area of connector is high. That is, in arrangements where the coolant is used for cooling also the contact, if the coolant passes the contact, it is heated up further. The coolant in the return line may heat up the line toward the connector. In this way, the heat of the contact is transported, at least in part, back to the contact. Such an interference is avoided by the solution as proposed herein, especially by the separation of the areas of effect of the cooling devices.

Instead of using this hot coolant for contact cooling, the first cooling device cools only the cables and not the contact. Contact cooling with a coolant would be challenging since in the area of the connector, and especially the area near the contacts, the thermal losses are relatively small but occur at high heat fluxes. Cooling such heat fluxes with a relatively hot coolant is inefficient.

Therefore, the second cooling device is configured for cooling the contact, independent from the first cooling device and the first cooling device reduces the end temperature of the cable coolant. This avoids measures as increasing flow rates for cooling additionally the contact, which would lead to a larger, more complex and less flexible cable, as well as to increased pressure losses and pumping power, or producing higher heat transfer areas, but this requires manufacturing connectors with a multitude of cooling channels, leading to complexity, high production costs and larger weight and size of the connector.

According to an embodiment, the second cooling device is a heat pipe comprising an evaporator connected to the contact and a condenser with integrated fins.

The cooling of the contact may be achieved by one or more heat pipes. The heat pipes have an evaporator thermally well connected to the electric contact on a first side, and a condenser with fins on the other side of the heat pipe otherwise extended surface is. Instead of fins, other elements could be used to enhance the surface, such as passive cooling elements comprising rips etc.

According to an embodiment, the second cooling device further comprises a fan configured for cooling the condenser.

Although passive convection can be considered at lower currents, one or more small fans may be used for forced convection of the heat pipe condenser, which results in an effective cooling of the condenser of heat pipe and hence allows for a significant increase of contact cooling. This allows also for a reduction of the required fin area. The fan is powered by electric power supplied from leads in the cable.

According to an embodiment, the fan is included outside of the internal enclosure.

The fan may be mounted on the outer surface of the internal enclosure and be oriented in direction of the fins or the condenser, respectively of the heat pipe.

According to an embodiment, the connector comprises an internal structure or a flow deflector for directing the airflow to the condenser, additional thermal spots and/or critical areas.

The airflow from the fan or the fans may be directed mainly to the condenser area, but it may be also separated and / or directed other thermal or critical spots inside the connector. For that, the connector may have an additional shaping, flow deflectors or other measures.

According to an embodiment, the second cooling device is a thermoelectric cell.

Therefore, the second cooling device could be a thermoelectric cell driven by the Peltier effect or a device where the coolant is evaporated. Thus, the second cooling system including the second cooling device does not necessarily have to be a liquid cooling system. It could also be a two-phase cooling system containing liquid and vapor, or an electric cooling system using a thermoelectric effect. Additional wires inside the cable may supply a thermoelectric system.

According to an embodiment, the external enclosure has openings configured to exchange hot air heated by a heat dissipater of the second cooling device with ambient air.

For example, the second cooling device is a heat pipe and a fan, and the heat dissipater is the condenser of the heat pipe. Then, the fan could be mounted such that it directs the airflow towards the openings where the condenser is in the airflow between the fan and the openings. However, the hot air may be exchanged in general with the ambient air through the openings.

There may be further openings on a further side of the enclosure. For example, if the fan provides an airflow to the first openings, air could be sucked from the further openings.

According to an embodiment, the EV charging connector comprises further a contact element. The contact element is composed of a bulky body being the part of the first portion and configured to receive wires of the cable and cooling lines being the first cooling device, and an elongated body being the second portion and configured to provide the contact to a pin of a vehicle socket. The contact element is designed such that the coolant of the lines flows only through the bulky body, and the second cooling device is attached to or integrated in the elongated body.

In other words, the contact element has two parts, the bulky body and the elongated body. The bulky body receives the cable including the cooling lines representing the first cooling device. The cable and the bulky body are the first portion of the connector in the area of effect of the first cooling device. The elongated body represents the contact and is the second portion of the connector in the area of effect of the second cooling device. The second cooling device may be a heat pipe or a thermoelectric cell.

According to a further aspect, an EV charging station comprising a cable, and an EV charging connector as described herein is provided. The charger station comprises further a first cooling system being configured to cool a first portion in the EV charging connector in an area of effect of the first cooling device, and a second cooling system configured to cool a second portion in the EV charging connector in an area of effect of the second cooling device. The first portion and the second portion are thermally connected to each other and the area of effect of the first cooling device is configured for not overlapping or only insignificantly overlapping the area of effect of the second cooling device.

The first and the second cooling system of the charging station therefore drive the active cooling device and the second cooling device of the EV charging connector. The second cooling system contains an element in contact with the electrical contacts through which the heat transfer takes place.

According to a further aspect, a use of a first cooling device and a second cooling device for an EV charging connector as described herein is provided.

These and other features, aspects and advantages of the present invention will become better understood with reference to the accompanying figures and the following description.

### Short Description of the Figures

Fig. 1 shows a diagram of a first example of the EV connector.
Fig. 2 shows a diagram of a second example of the EV connector.
Fig. 3 shows a diagram of a second example of the EV charging station.
Fig. 4 shows a diagram of a contact element

### Detailed Description of Embodiments

Corresponding parts are provided with the same reference symbols in all figures.

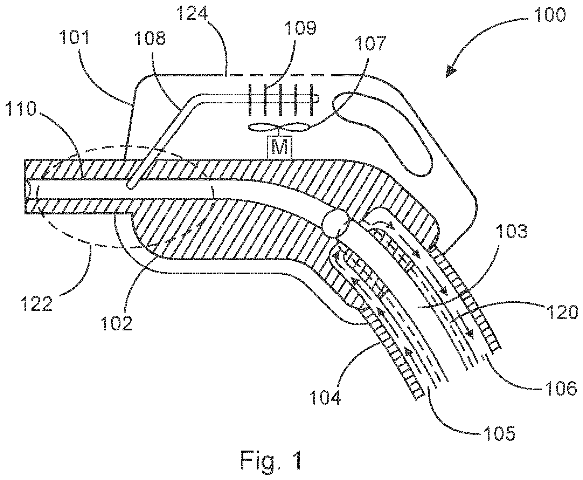

Fig. 1 shows a diagram of a first example of the EV connector 100. Connector 100 comprises a contact 110 and a cable 104. The cable contains at least conductor 103 and an active cooling device 105, 106, with a fluid line 105 that transports a fluid towards the connector and a fluid line 106 that transports a fluid from the connector to a charging station.

The fluid is a coolant. The fluid therefore circulates driven inside these lines driven by pump of a charging station. The connector 100 further comprises passive cooling device 108, for example a heat pipe that transports heat from the contact 110 to a condenser area with fins 109 where the transported heat is dissipated. The connector 100 in this example has further a fan 107 that is driven by a motor M, which is supplied with current from additional wires in the cable 103. The contact 110 is inside an internal enclosure 102, where also the connection of conductor 103 with contact 110 is located. The internal enclosure 102 is electrically and environmentally sealed. The external enclosure 101 encloses the internal enclosure 102, the heat pipe 108 with fins 109 and fan 107. The external enclosure 101 has openings 124 near fins 109.

The heat pipe 108 is attached to the contact 110 near the front of the internal enclosure 110, where "front" is the direction towards the interface to a vehicle socket. The area of effect 120 of the heat pipe 108 is near to the point where it is attached and indicated by a dotted circle 122 in Fig. 1. The active cooling device, that is, lines 105, 106 has an area of effect 122, indicated by dotted curve 120 in Fig. 1. The both areas of effect 120, 122 do not overlap. In this way, on one they are fully effective and do not interfere with each other. On the other side, the cooling result of the active cooling device 105, 105 is beneficial for the effectiveness of the heat pipe 108.

Opposed to usual designs, the coolant, which may already be heated up due to the heat that it has absorbed from the cable 104, is not used to absorb also the heat from the contact 110, which would be ineffective anyway because of the high heat flux in the contact 110. Instead, it effects a decrease of the temperature of the cable 104 only. The contact 110 on the other side is cooled by the heat pipe 108 only such that the coolant is not heated up further. The heat pipe 108 - as a good heat conductor - conducts the heat effectively away from the contact 110, i.e., much more effective than the coolant would be able to do. Therefore, the heat pipe 108 effects that the contact 110 is cooled and less heat is flowing to the cable 104; and the cable 104 is cooled by the coolant not heating up the contact 110 further. Both cooling devices 108, 105, 106 are effective in their application area 122, 120. The heat pipe 108 is suitable for the high heat flux in the contact 110 and the coolant is suitable for the low heat flux in the cable 104. Further, a de-coupling of the heat sources is obtained.

The openings 124 provide an exchange of the hot air in the connector 100 with the ambient air. The fan 109 is located between the inner enclosure 102 and the fins 109 so that the air accelerated by the fan 107 flows around the fins 109 and passes openings 124 to the outside of the external enclosure 101.

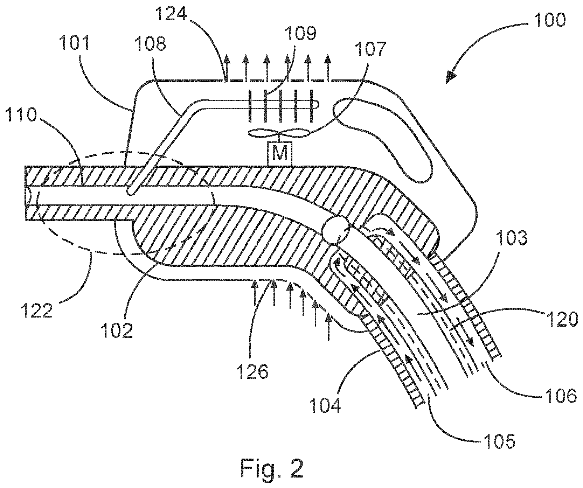

Fig. 2 shows a diagram of a second example of the EV connector 100. The external connector 101 has additional openings 106 at the bottom side of the connector 100 so that an airflow is provided through the connector 100. The airflow is generated by the fan 109, which blows the air through the openings 124, and thus the ambient air is drawn in through the openings 126 on the bottom side of the connector 110 by the resulting negative pressure. Since airflow from the openings 216 passes also the inner enclosure, it also has an cooling effect on this enclosure. The openings could be located at other places.

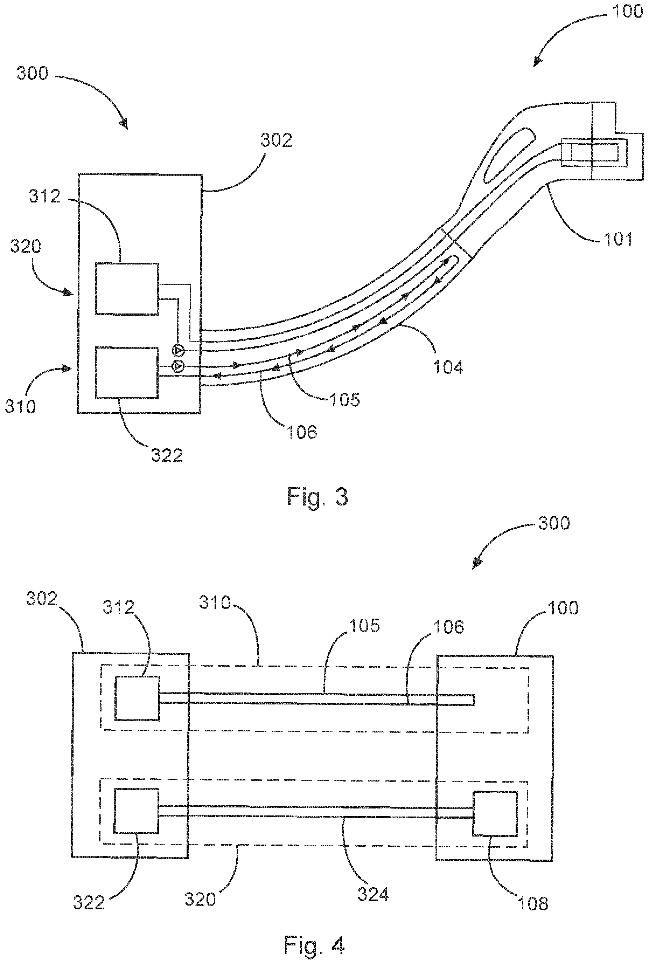

Fig. 3 in combination with Fig. 4 shows a diagram of an EV charging station 300. The charging station 300 comprises a charging post 302, the EV charging connector 100, cable 104 and two different cooling systems 305, 306. The term "charging post" is used herein for distinction from the "charging station". In this disclosure, "charging post 302" refers to the fix part of the charging station without EV charging connector 100 and cable 104.

The first cooling system 310 is configured to cool the first cooling area 120, and the second cooling system 320 is configured to cool the second cooling area 122. The first cooling system 310 may comprise a pump (not shown in Fig. 3) for driving a coolant through lines 105 and 106, a control circuit 322 for operating and controlling the pump 324, and electric support lines for second cooling device.

The end of the lines 105, 106 may be before entering the connector 100, or at the back end of the connector 100 as shown in Figs. 1 and 2. The second cooling system 320 may comprise a circuit 312 that drives and/or controls an active component of the second cooling device 108. The second cooling device 108 may be a fan and the corresponding active component a fan 107 as shown in Figs. 1 and 2. Alternatively, it may be a thermoelectric cell.

Therefore, the second cooling system 320 contains an element 108 in contact with the electrical contacts 110 through which the heat transfer takes place. The device 108 could be a thermoelectric cell powered by Peltier effect, or a device where evaporation of the coolant occurs. Thus, cooling system 320 need not be a liquid cooling system but a bi-phase cooling system, incl. liquid and vapor, or an electrical cooling system that uses a thermoelectric effect.

Thus, the first cooling system 310 is responsible of cooling the cable alone, and the cooling system 320 is responsible for cooling the contacts alone.

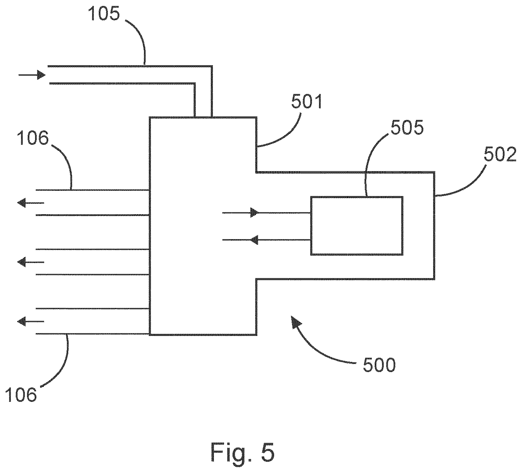

Fig. 5 shows a diagram with a contact element 110 consisting of a bulky body 501 and an elongated body 502. The contact element 500 may have a round or cylindrical shape, or a flat, that is, rectangular shape. The cable cooling lines 105, 106 reach only the bulky body 501 through the feeding line 105, and the coolant goes back to the charging post 302 through channels 106 containing the copper wires. The elongated body 502, which may correspond to contact 110, in turn, is cooled by a different system 505, which could be a thermoelectric cell 505, e.g. a Peltier cell (powered by electrical wires) or a cell capable of bi-phase cooling. The cell 505 capable of bi-phase cooling may be connected to one or more devices 322 such as a compressor, heat exchanger and pump in the charging post 302.

Other variations to the disclosed embodiments can be understood and effected by those skilled in the art in practicing the claimed invention, from the study of the drawings, the disclosure, and the appended claims. In the claims, the word "comprising" does not exclude other elements or steps and the indefinite article "a" or "an" does not exclude a plurality. A single processor or other unit may fulfill the functions of several items or steps recited in the claims. The mere fact that certain measures are recited in mutually different dependent claims does not indicate that a combination of these measures cannot be used to advantage. Any reference signs in the claims should not be construed as limiting the scope of the claims.

### Reference Numerals

- 100: EV charging connector
- 101: external enclosure
- 102: internal enclosure
- 103: conductor inside the cable
- 104: cable
- 105: first cooing device / fluid line towards the connector
- 106: first cooing device / fluid line from the connector to the charging station
- 107: fan
- 108: second cooling device (heat pipe / Peltier element)
- 109: fins
- 110: contact
- 120: first cooling area / area of effect of the fluid line
- 122: second cooling area / area of effect of the heat pipe
- 124: first openings in the enclosure
- 126: second openings in the enclosure
- 300: charging station
- 302: charging post
- 310: first cooling system
- 312: device for controlling and/or operating first cooling system
- 320: second cooling system
- 322: device for controlling and/or operating second cooling system
- 324: electric support lines for second cooling device
- 500: contact element
- 501: bulky body of the contact element
- 502: elongated body / contact
- 505: thermoelectric cell

## Claims

1. EV charging connector (100) comprising
a hybrid cooling system with
a first cooling device (105, 106) for cooling a first portion (120) of the connector (100) in an area of effect (120) of the first cooling device (105, 106), and
a second cooling device (108) for cooling a second portion (122) of the connector (100) in an area of effect (122) of the second cooling device (108); wherein
the first portion and the second portion are thermally connected to each other; and
the area of effect (120) of the first cooling device (105, 106) is configured for not overlapping or only insignificantly overlapping the area of effect of the second cooling device (108).

2. EV charging connector (100) according to claim 1, wherein
the EV charging connector (100) comprises a cable (103) and a contact (110); and wherein
the first portion is the cable (104) and the second area is the contact (110).

3. EV charging connector (100) according to claim 1 or 2, wherein the first cooling device (105, 106) is configured to cool the cable (103) actively by pumped coolant, and the second cooling device (108) is configured for cooling the contact (110).

4. EV charging connector (100) according to any one of the previous claims, wherein the second cooling device (108) is a heat pipe (108) comprising an evaporator connected to the contact (110) and a condenser with integrated fins (109).

5. EV charging connector (100) according to claim 4, wherein the second cooling device (108) further comprises a fan (107) configured for cooling the condenser.

6. EV charging connector (100) according to claim 5, wherein the fan (107) is included outside of the internal enclosure (102).

7. EV charging connector (100) according to claim 5 or 6, wherein the EV charging connector (100) comprises an internal structure or a flow deflector for directing an airflow from the fan (107) to the condenser, additional thermal spots and/or critical areas.

8. EV charging connector (100) according to any one of the previous claims, wherein the second cooling device (108) is a thermoelectric cell (505).

9. EV charging connector (100) according to any one of the previous claims, wherein the external enclosure has openings (124, 126) configured to exchange hot air heated by a heat dissipater of the second cooling device (108) with ambient air.

10. EV charging connector (100) according to any one of claims 3 to 9, wherein
the EV charging connector (100) comprises further a contact element (500); wherein
the contact element (500) is composed of
a bulky body (501) being the part of the first portion and configured to receive wires of the cable and cooling lines (105, 106) being the first cooling device (105); and
an elongated body (502) being the second portion and configured to provide the contact to a pin of a vehicle socket; and wherein
the contact element (500) is designed such that the coolant of the lines (105, 106) flows only through the bulky body (501), and the second cooling device (108) is attached to or integrated in the elongated body (502).

11. EV charging station (300) comprising a cable (104), and an EV charging connector (100) according to any one of the previous claims; wherein the charger station comprises further
a first cooling system (305) being configured to cool a first portion in the EV charging connector (100) in an area of effect (120) of the first cooling device (105); and
a second cooling system (306) configured to cool a second portion in the EV charging connector (100) in an area of effect (122) of the second cooling device (108), wherein
the first portion (120) and the second portion (122) are thermally connected to each other; and
the area of effect (120) of the first cooling device (105) is configured for not overlapping or only insignificantly overlapping the area of effect (122) of the second cooling device (108).

12. Use of a first cooling device (105, 106) and a second cooling device (108) for an EV charging connector (100) according to any of claims 1 to 10.
